Europäisches Patentamt

European Patent Office

Office européen des brevets

(11) Publication number: **0 361 339**
**A1**

## EUROPEAN PATENT APPLICATION

(21) Application number: **89117604.2**

(22) Date of filing: **23.09.89**

(51) Int. Cl.5 **G01R 31/16**

(30) Priority: **30.09.88 SE 8803476**

(43) Date of publication of application:
**04.04.90 Bulletin 90/14**

(84) Designated Contracting States:
**AT BE CH DE FR GB IT LI**

(71) Applicant: **ASEA BROWN BOVERI AB**

**S-721 83 Västeras(SE)**

(72) Inventor: **Heyman, Olof**
**Dragonstigen 11**
**S-771 00 Ludvika(SE)**

(74) Representative: **Boecker, Joachim, Dr.-Ing.**
**Rathenauplatz 2-8**
**D-6000 Frankfurt a.M. 1(DE)**

(54) **Method and device for corona testing of oil-submerged insulators.**

(57) Method and device for corona testing of oil-submerged insulators (1), preferably of lower insulators used in bushings, said insulators having an outer and an inner largely cylindrically and/or conically formed surface. The corona testing is performed with the aid of one electrode which is connected to ground and another electrode which is connected to a test voltage. According to the invention the outer surface of the insulator (1) is surrounded by a first electrode (2), and a second electrode (8) is connected to the inner surface of the insulator. The electrodes have largely or precisely the same shape as the outer and inner surface, respectively, of the insulator. Either both the first and the second electrode consist of conducting rubber (2) or of metal a sleeves (8) or one of said two electrode consist of conducting rubber while the other consist of a metal sleeves. The test voltage is connected to any one of the first or second electrode.

*FIG. 2*

EP 0 361 339 A1

## Method and device for corona testing of oil-submerged insulators

The invention relates to a method for corona testing of oil-submerged insulators according to the precharacterising part of claim 1 and a device for carrying out the method.

The invention particularly relates to such insulators used for the lower part of bushings. Such bushings in question have a working range which is largely between 50 and 1000 kV. The two media to be connected by the bushings are normally oil and air, for example for transformers, or oil and $SF_6$-gas, or $SF_6$-gas and -$SF_6$-gas, or $SF_6$-gas and air for switchgear.

Bushings of the afore-mentioned type are built up around a through-going and connecting centre tube. A condenser body of high-quality cable paper alternating with condenser films of aluminum foils or the like are wound on the tube in order to obtain a favourable electrical field distribution around the fastening flange of the bushing. The current conductor may be a flexible or rigid metal conductor drawn into the centre tube. Further, the bushing comprises one upper and one lower insulator which are each connected to a respective side of the fastening flange. The space between the condenser body and the insulator is filled with transformer oil. The upper insulator which is surrounded by air or gas is made in one piece of electric porcelain. The lower insulator is submerged in oil or in $SF_6$-gas and is also made of electric porcelain.

The design in broad outline, the manufacture and the testing of the bushings to be used are regulated by IEC standards, such as IEC 137, dealing with bushings for alternating voltages above 1000 V, and IEC 270, dealing with partial discharge measurements.

The manufacturing process and the completion of the bushings are continuously inspected. For example, a tightness test is carried out on each bushing after it has been mounted, dried and oil-impregnated. An internal oil overpressure is established at ambient temperature for 12 hours whereupon it is checked that no oil has leaked out.

Each bushing is also subjected to electrical tests. These are carried out at room temperature and with the oil side of the bushing submerged in oil. Capacitance, $\tan\delta$ and internal partial discharge are measured at a voltage increasing in steps up to full test voltage equal to twice the rated voltage. Full test voltage is upheld for 1 minute whereupon the voltage is reduced in the same steps as it had been increased before, the measurements then being repeated. As an example can be mentioned that the approval limit for the partial discharge test is 10 pC at the most at a voltage 50% above the maximum phase-to-earth voltage of the system.

If corona is determined, the bushing has to be dismantled and that part of the bushing where corona has occurred must somehow be identified and then replaced, whereafter the bushing must be reassembled, tested for tightness etc., and subjected to new electrical tests.

If a corona test does not exhibit acceptable values, the extra amount of work that has to be carried out in connection with dismantling, identification and replacement of the faulty component, reassembly, and new testing, entails a rather significant expenditure of time and costs. Bushings for the higher voltage ranges may have an axial length of up to 15 m and a weight of up to 3000 kg.

It is self-evident, therefore, that it would be of great economical and labour-saving value if it were possible in some way to test the relevant parts of a bushing, thus making it possible, even before assembly, to exclude such specimens as could give rise to inadmissible corona. The actual corona test unfortunately provides little information as to which parts of the bushings could give rise to inadmissible corona. By replacing possible source parts of the error, it has been found, after lengthy studies, that in the majority of cases the lower insulator has been the villain in the bushing. After replacement of the lower insulator by one from a faultless bushing, it is normally found that the corona test is satisfactory.

Different theories have been proposed to try to explain the reason for the occurrence of corona. The theory that has proved to be correct is that the insulator contains a porosity or other defects that may cause corona. To confirm this theory more closely, a number of lower insulators, both such as have not given rise to corona and such as have shown corona, have been investigated in detail.

The lower insulator is formed as a partly cylindrical and partly conical sleeve with an axial length which may vary, depending on the working voltage, largely between 200 and 1000 mm. The largest diameter of the insulator makes contact, via rubber gaskets, with the fastening flange of the bushing. Contrary to the upper insulator, which is formed with a plurality of shields or grooves in order to obtain a long creeping path, the outer surface of the lower insulator has no, or only a few, shields or grooves.

Because of the shape of the lower insulator and the size of the pores, the diameter of which ranges from 0.1 mm to 20 mm, it is very difficult to perform an X-ray analysis to detect any porosity.

Another method of control is to perform an ultrasonic examination of the lower insulator. When having tested lower insulators with the ultrasonic method, indication was obtained for those insulators that had given rise to corona, but also for some of those lower insulators that had been mounted on bushings which had withstood the electric test without inadmissible corona.

After completion of ultrasonic examination, the insulators were destroyed in order to see whether the indications emanated from pores in the material. In the insulators in which corona has occurred and which indicated inhomogeneities, pores of the order of size of between 0.4 and 2 x 20 mm were found. However, the connection between the magnitude of the ultrasonic indication and the extension of the pore does not seem to be completely clear. For pores above a certain length, the indications have in all cases been considerable. However, it was found that small indications on corona-free lower insulators could not be traced to any pores. Thus, it seems that ultrasound may be a method which shows whether there are large pores, whereas, in the case of smaller indications, it sometimes gives a false alarm.

To sum up, it can be said that although the ultrasonic method is considerably better than the X-ray method, also the ultrasonic method leaves a great deal to be desired. In the first place, the method is very time-consuming. Even with an automated detection, unreasonable long times of examination must be accepted. In the second place, the possibilities of detecting a pore are deteriorated when the radii are too small. This is particularly true of shields or grooves. In the third place, an indication of inhomogeneities is sometimes obtained without any pores existing. This means that, if the ultrasonic method is used for sorting out insulators which may give rise to inadmissible corona, insulators which could give an acceptable test result might be eliminated. This fact, combined with the necessary time expenditure for examining the surface of the whole insulator as well as the difficulties with the shields mentioned above, contribute to make the ultrasonic examination of lower insulators less suitable and reliable.

The known art for inspecting a lower insulator with respect to the corona propensity prior to assembly of a bushing is both unreliable and exceedingly difficult to perform, as has been described above.

The invention aims to develop a method and a device for corona testing of oil-submerged insulators, particularly of lower insulators for bushings, which method and device are simple and reliable and allow performing the test directly on the insulator prior to its assembly with further parts to form a larger component, such as a bushing.

To achieve this aim the invention suggests a method for corona testing of oil-submerged insulators according to the introductory part of claim 1, which is characterized by the features of the characterizing part of claim 1.

A device for carrying out the method is characterized by the features of claim 2.

A further development of this device is characterized by the features of claim 3.

The invention permits the insulator to be subjected to the same electrical stress as when performing a routine test of a larger complete component, such as a bushing, in a very simple and reliable manner and with a considerably lower test voltage than during a routine test.

The method is based on a stocking of conducting rubber being pulled over the outer edges of the insulator. Because of the elasticity of the rubber, the stocking will confirm tightly to the outer envelope surface of the insulator.

By forming an inflatable balloon of the same conducting rubber which is pre-formed to correspond largely to the inner contour of the insulator, a tight contact with the inner wall surfaces of the insulator is also obtained. Since measurement of corona is to take place between the two rubber electrodes, the entire test device must be submerged in transformer oil. If this is not done, corona will occur in the surrounding air a long time before it occurs in any pores in the insulator. When performing the test the rubber electrode placed inside the insulator is energized, whereas the outer rubber electrode is grounded or vice versa. Any corona will be detected between the electrodes. The desired field strength $E_p$ in the porcelain is obtained as a result of the tightly connected electrodes with an applied voltage

$$U = E_p \cdot t_p \qquad (1)$$

where $t_p$ is the thickness of the porcelain.

The inner surface of the lower insulator has no projecting shields, i.e. it has a more pure, cylindrical and conical shape, respectively. A modification of the method according to the invention comprises manufacturing the inner electrode of metal. Since such a metal electrode cannot be caused, by any reasonable means, to conform tightly to the inner conical surface of the insulator, there will be a space between the sleeve-formed metal electrode and the inner surface of the insulator. This space will be filled with oil during the test. When testing according to this method, the test voltage will consequently have to be increased in relation to testing with a conducting inner rubber electrode.

A further modification of the method according to the invention is to allow both the inner and outer electrode to consist of metal. Because the outer surface of the lower insulator often comprises shields or grooves, it is also not possible to cause an outer metallic electrode to be directly connected to the surface of the insulator. Consequently, also in this case a gap will form which, when performing the

3

test, will be filled with transformer oil. For the alternatives using metallic electrodes, the electric field applied during the test will be distributed as follows

$$\frac{E_p}{E_o} = \frac{\varepsilon_o}{\varepsilon_p} = \frac{2}{6} \qquad\qquad (2)$$

where $E_o$, as before, is the electric field strength in the porcelain. $E_o$ is the electric field strength in oil. $\varepsilon_p = 6$ is the relative permittivity of the porcelain, and $\varepsilon_o = 2$ is the relative permittivity of the oil. The necessary test voltage between the electrodes will thus be

$U = t_p \cdot E_p + t_o \cdot E_o \qquad (3)$

where $t_p$, as before, is the thickness of the porcelain, and $t_o$ is the total gap thickness of the oil. From the above it is clear that the test voltage with the metal electrode will be

$U = E_p(t_p + 3t_o) \qquad (4)$

From equation (4) it is quite clear that the thickness of the oil gap has a very significant influence on what kind of test voltage is needed to obtain the desired field strength $E_p$ in the porcelain. Thus, a considerably higher test voltage is needed for the two variants using metal electrodes.

By way of example, the invention will now be described in greater detail with reference to the accompanying drawings showing in

Figure 1 a preferred embodiment of a measuring device comprising two electrodes of conducting rubber to perform a corona test of a lower insulator of a bushing,

Figure 2 an alternative to the embodiment according to Figure 1, with one of the rubber electrodes being replaced by a metallic electrode,

Figure 3 a further alternative to the embodiment according to Figure 1. with both of the rubber electrodes being replaced by metallic electrodes.

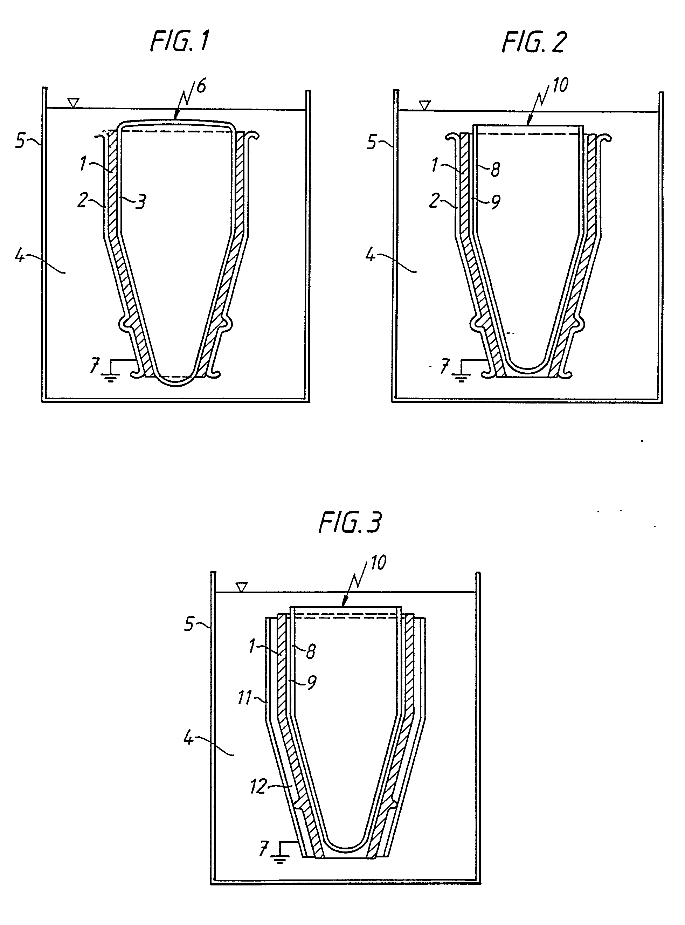

With the preferred embodiment of a device according to Figure 1 for carrying out the method for corona testing of lower insulators a stocking 2 of a conducting rubber material, for example nitrile rubber, is pulled over the lower insulator 1. The inner surface of the lower insulator 1 is covered with a similarly conducting rubber layer 3, possibly consisting of a balloon expanded by means of overpressure. The measuring device and the partly cone-shape insulator are submerged in a vessel 5 filled with transformer oil 4. The testing is performed by connecting the test voltage, for example as shown at 6, to the inner rubber electrode 3. In a corresponding manner, ground potential is then connected to the outer rubber electrode 2.

An alternative embodiment of the device according to the invention will be clear from Figure 2. The lower insulator 1 is here surrounded, in the same way as in Figure 1, by a stocking 2 of conducting rubber. The entire device is submerged in a vessel 5 filled with oil 4. Inside the insulator 1 there is now a cylindrical and partly conical sleeve 8 of metal having largely the same shape as the inner conical surface of the insulator 1, whereby an oil gap 9 is formed between the metal sleeve and the inner cylindrical and conical surface of the insulator 1. The measuring voltage is applied to the metal sleeve at 10 and ground potential is connected to the conducting stocking at 7. The metal sleeve can, of course, be formed in a variety of different ways, for example as a cylindrical or cone of sheet metal or in the form of a more or less fine-meshed metal net, all within the scope of the invention.

An additional alternative embodiment of the device according to the invention will be clear from Figure 3. The lower insulator 1 is here surrounded by a metal electrode 11, also formed as a sleeve, whereby an oil gap 12 is formed between this electrode and the outer surface of the insulator, in the figure drawn as a cylindrical and conical surface without shields or grooves. In this embodiment the inner electrode has the same metallic electrode as that shown in Figure 2.

An embodiment within the scope of the invention comprises replacing only the outer rubber electrode with a cylindrical and conical sleeve of metal, possibly formed of a fine-meshed metal net.


## Claims

1. Method for corona testing of oil-submerged insulators (1), preferably of lower insulators used in bushings, said insulators having an outer and an inner largely cylindrically and or conically formed surface, the corona testing being performed with the aid of one electrode which is connected to ground and another electrode which is connected to a test voltage, **characterized** in that the outer surface of the insulator (1) is surrounded by a first electrode (2,11), that a second electrode (3,8) is connected to the inner surface of the insulator, that these electrodes have largely or precisely the same shape as the outer and inner surface, respectively, of the insulator, and that either both the first and the second electrode consist of conducting rubber (2,3) or of metal sleeves (8,11), or one of said two electrode consist of conducting rubber while the other consist of a metal sleeves, and that the test voltage is connected to any one of the first or second electrode.

2. Device of carrying out the method for corona testing of oil-submerged insulators (1), preferably for lower insulators used in bushings, said insulator having an outer and an inner largely cylindrically and/or conically formed surface, the corona testing being performed with the aid of one electrode which is connected to ground and another electrode which is connected to a test voltage, **characterized** in that a first electrode (2,11) is arranged outside the outer surface of the insulator (1) and a second electrode (3,8) is arranged against the inner surface of the insulator,

that both the first and second electrodes are made of conducting rubber and the first electrode is arranged as a stocking (2) applied outside the outer surface of the insulator, and the second electrode is arranged as a balloon (3) which conforms to the inner surface of the insulator,

or that both the first and second electrodes are arranged as sleeves (11,8) of metal having largely the same shape as the outer and inner surfaces, respectively, of the insulator,

or that one of electrode is arranged as a stocking of conducting rubber applied to the corresponding surface of the insulator while the other electrode is arranged as a sleeve of metal having largely the same shape as the corresponding surface of the insulator,

and that the test voltage may be connected to any one of the first or second electrode.

3. Device according to claim 2, **characterized** in that an electrode which consist of a metal sleeve is formed of a metallic net.

20.09.1989
22 179 PE

FIG.1

FIG.2

FIG.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| A | GB-A-1 117 155 (KABEL-UND METALLWERKE, GUTEHOFFNUNGSHÜTTE AG) *Claim 1* | 1-3 | G 01 R 31/16 |
| A | DE-A-1 591 930 (KABEL-UND METALLWERKE, GUTEHOFFNUNGSHÜTTE AG) *Claim 1* | 1-3 | |

TECHNICAL FIELDS SEARCHED (Int. Cl.4)

G 01 R

The present search report has been drawn up for all claims

| Place of search | Date of completion of the search | Examiner |
|---|---|---|
| STOCKHOLM | 28-11-1989 | WIRLÉE S. |

EPO Form 1503 03 82